Europäisches Patentamt

European Patent Office

Office européen des brevets

(11) Veröffentlichungsnummer: **0 290 830 B1**

## (12) EUROPÄISCHE PATENTSCHRIFT

(45) Veröffentlichungstag der Patentschrift: **30.09.92**

(21) Anmeldenummer: **88106347.3**

(22) Anmeldetag: **21.04.88**

(51) Int. Cl.⁵: **H03D 1/22**, H04H 1/00

(54) **Demodulator zur Demodulation von Eingangssignalen.**

(30) Priorität: **09.05.87 DE 3715571**

(43) Veröffentlichungstag der Anmeldung:
**17.11.88 Patentblatt 88/46**

(45) Bekanntmachung des Hinweises auf die
Patenterteilung:
**30.09.92 Patentblatt 92/40**

(84) Benannte Vertragsstaaten:
**AT CH DE ES FR GB IT LI NL SE**

(56) Entgegenhaltungen:
**EP-A- 0 256 287**
**DE-A- 3 433 592**

**EBU REVIEW-TECHNICAL, Nr. 204, April 1984,
Seiten 50-58, Brüssel, BE; S.R. ELY et al.:
"Design principles for VHF/FM radio receivers using the EBU radio-data system RDS**

(73) Patentinhaber: **Blaupunkt-Werke GmbH
Robert-Bosch-Strasse 200
W-3200 Hildesheim(DE)**

(72) Erfinder: **Hegeler, Wilhelm
Grosse Venedig 23
W-3200 Hildesheim(DE)**

(74) Vertreter: **Eilers, Norbert, Dipl.-Phys.
Blaupunkt-Werke GmbH Robert-
Bosch-Strasse 200
W-3200 Hildesheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft einen Demodulator gemäß dem Oberbegriff des Anspruchs 1. Ein solcher Demodulator ist in der älteren europäischen Patentanmeldung EP-A-0 256 287, veröffentlicht am 24.2.1988, beschrieben.

Demodulatoren dieser Gattung werden vor allem für Autoradios mit einer Verkehrsfunk (VRF)-Kennung benötigt, bei denen zusätzlich sogenannte RDS (Radiodata-System)-Informationen decodiert werden.

Es ist schon bekannt, dem Autofahrer zur Verbesserung des Verkehrsablaufes und zur Erhöhung der Verkehrssicherheit über bestimmte Rundfunksender (Verkehrsfunksender) Verkehrshinweise zu geben. Um dabei dem Autofahrer das Aufsuchen des für seinen örtlichen Bereich zuständigen Verkehrsfunksenders zu erleichtern, wird in üblicher Weise ein bekanntes Kennungssytem - nachfolgend auch als VRF-System bezeichnet - eingesetzt, welches drei Kennfrequenzen verwendet, die im UKW-Bereich zusätzlich zur Nutzmodulation des FM-Verkehrsfunksenders aufmoduliert werden. Für die Senderkennung ist dabei ein 57 kHz-Träger vorgesehen, der zur Kennzeichnung aller Verkehrsfunksender dient.

Neben dem VRF-System ist zusätzlich auch noch das RDS-System bekannt ("Specification of the radio data System RDS", Sonderdruck der EBU Technical centre, Brüssel, Tech. 3244 E, März 1984), welches die Übertragung von Informationen ermöglicht, die beispielsweise die Art des jeweiligen gesendeten und empfangenen Programmes (Programmtyp), eine Senderidentifikation, alternative Senderfrequenzen usw. betreffen.

Bei dem RDS-System erfolgt die Übertragung der RDS-Informationen in Form von digitalen Signalen auf einem Unterträger von 57 kHz über UKW-Rundfunksender, wobei eine Zweiseitenbandamplitudenmodulation des 57 kHz-Trägers (Träger wird unterdrückt) mit dem biphasecodierten Datensignal erfolgt. Durch die Biphase-Codierung erscheinen in der Nähe des Trägers keine Spektrallinien, so daß eine Kompatibilität mit dem VRF-System gegeben ist.

Somit besteht also grundsätzlich in vorteilhafter Weise die Möglichkeit, sowohl VRF-Signale und/oder RDS-Signale zu übertragen, und empfängerseitig stellt sich dann die Forderung nach einem Demodulator, der die Rückgewinnung der gesendeten aufmodulierten VRF-Signale und RDS-Signale gewährleistet. Zu diesem Zweck werden Demodulatoren gemäß der eingangs genannten Gattung verwendet.

Beim Einsatz eines Demodulators nach dem PLL-Prinzip läßt sich die obige Forderung in der Praxis aber nicht erfüllen. Der PLL-Demodulator kann nämlich nur für den Fall VRF = 1 einrasten, wenn also der 57 kHz-Träger vorhanden ist. Im Falle VRF = 0, wenn kein Träger vorhanden ist, läßt sich ein RDS-Signal nicht demodulieren. Dies bedeutet, das mit einem PLL-Demodulator RDS-Signale nur dann gewonnen werden können, wenn der 57 kHz-Träger vorhanden ist (VRF = 1).

Mit einem in der bereits genannten älteren Anmeldung beschriebenen Demodulator nach dem sogenannten "Costas-Loop-Prinzip" ist es demgegenüber zwar grundsätzlich möglich, auch im Falle VRF = 0 ein RDS-Signal zu demodulieren und zu erhalten, allerdings besteht dabei der Nachteil, daß das RDS-Signal - in Abhängigkeit der Möglichkeiten VRF = 0 oder VRF = 1 - an unterschiedlichen Ausgangsklemmen abgegriffen werden muß.

An einer ersten Ausgangsklemme erscheint das RDS-Signal für den Fall VRF = 0, während an dieser Klemme für den Fall VRF = 1 das VRF-Signal abgegriffen werden kann. An einer zweiten Ausgangsklemme steht das RDS-Signal nur dann zur Verfügung, wenn der 57 kHz-Träger vorhanden ist (VRF = 1).

Da die RDS-Signale in Abhängigkeit von dem Vorhandensein des 57 kHz-Trägers an unterschiedlichen Ausgangsklemmen auftreten, läßt sich diese Costas-Loop-Schaltung in der Praxis nicht einsetzen. Es wäre nämlich ein erheblicher zusätzlicher elektronischer Schaltungsaufwand erforderlich, um unabhängig für die Fälle VRF = 0 und VRF = 1 zu gewährleisten, daß das RDS-Signal immer an derselben Ausgangsklemme zur Verfügung steht.

In der bereits genannten älteren Anmeldung ist ein Demodulator vorgeschlagen, bei dem mit einfachen Schaltungsmaßnahmen erreicht wird, daß das RDS-Signal unabhängig von der Anwesenheit eines VRF-Trägers an einem ganz bestimmten Ausgang entsteht und zur Weiterverarbeitung abgenommen werden kann.

Bei dem Demodulator gemäß der bereits genannten älteren Anmeldung wird mittels einer schnellen VRF-ErkennungsSchaltung die Steuergröße der Costas-Loop zwischen dem Costas-Mischer und einem gegebenenfalls nachgeschalteten Tiefpaß invertiert und damit eine 90°-Drehung des stabilen Zustandes herbeigeführt. Es liegt dann praktisch eine Costas-Loop-Schaltung vor, bei der das RDS-Signal in gewünschter Weise immer an derselben Ausgangsklemme zur Verfügung steht, d.h., der Demodulator ist sowohl im Falle VRF = 0 als auch im Falle VRF = 1 stabil eingerastet, und in beiden Fällen entsteht das RDS-Signal an einer bestimmten Ausgangsklemme.

Für die VRF-Erkennung kann dabei in zweckmäßiger Weise die Information dienen, daß innerhalb der letzten RDS-Periode eine der beiden Sinus-und Cosinuskomponenten frei von Vorzeichenwechseln gewesen ist, denn dann gilt VRF = 1.

Bei diesem Demodulator gemäß der älteren Anmeldung arbeitet die Phasenregelschleife immer in einer Costas-Wirkungsweise, wobei in Abhängigkeit des VRF-Pegels lediglich eine Invertierung des Steuersignals für den Oszillator erfolgt. Die für eine Costas-Wirkungsweise typische Eigenschaft, die in einer Zweideutigkeit der Phase um 180° liegt, bleibt also erhalten, und zwar auch dann, wenn der Demodulator bei vorhandenem VRF-Pegel einrastet.

Um neben dem RDS-Signal auch eine eindeutige Erkennung des VRF-Signals zu ermöglichen, wäre deshalb eine gezielte Information darüber erforderlich, wie bzw. mit welcher Phase die Phasenregelschleife eingerastet ist. Die bezüglich des VRF-Signals gegebene Zweideutigkeit ist zwar für die eindeutige Demodulation des RDS-Signals unbedeutend, sie spielt aber für die VRF-Demodulation eine wichtige Rolle. Dies bedeutet mit anderen Worten, daß der in der älteren Anmeldung beschriebene Demodulator im Grunde genommen nur als ein RDS-Demodulator zu verwenden ist, während ein Einsatz als VRF-Demodulator wegen der beschriebenen Ungenauigkeit und Zweideutigkeit bezüglich der Phase zu nicht eindeutigen Demodulationsergebnissen führen würde.

Nun ist zwar die Erkennung der Zweideutigkeit bzw. des 180°-Phasenfehlers prinzipiell durch Schaltungsmaßnahmen möglich, allerdings wird sich dabei zwangsläufig in nachteiliger Weise eine Zeitkonstante ergeben, und ferner ist zu berücksichtigen, daß die Phasenlage und damit die Zweideutigkeit der Phase um 180° bei jeder Störung wieder umkippen kann, und daß dann neben der Störungserkennung eine erneute Definition der Phase erforderlich wäre.

Der Erfindung liegt die Aufgabe zugrunde, den in der älteren Anmeldung beschriebenen Demodulator in der Weise zu verbessern, daß die Möglichkeit besteht, neben dem RDS-Signalen auch den VRF-Träger in eindeutig definierter Phase zurückzugewinnen, um anschließend eine Demodulation durchführen zu können.

Die Lösung dieser Aufgabe erfolgt bei dem im Oberbegriff des Anspruchs 1 genannten Demodulator durch die im kennzeichnenden Teil angegebenen Merkmale.

Bei der Erfindung arbeitet der Demodulator nicht mehr ausschließlich in einer Costas-Wirkungsweise, bei der Mischprodukte aus den Sinus- und Cosinuskomponenten zur Phasenregelung herangezogen sind. Vielmehr ist vorgesehen, die Phasenregelschleife des Demodulators in Abhängigkeit des VRF-Pegels in eine normale PLL-Wirkungsweise umschaltbar auszubilden, bei der entweder nur die Sinuskomponenten oder nur die Cosinuskomponenten zur Phasenregelung herangezogen sind.

Durch das neuartige Umschalten der entsprechenden Steuergrößen für den Oszillator läßt sich der Demodulator neben den RDS-Signalen nunmehr auch gleichzeitig als VRF-Demodulator verwenden, wobei die bei der Costas-Wirkungsweise gegebene typische Zweideutigkeit der Phase entfällt.

In einer zweckmäßigen Ausgestaltung der Erfindung erfolgt die Umschaltung mittels eines am Ausgang des Costas-Mischers angeordneten zweistufigen Schalters, durch den ein auf den Costas-Mischer folgender Integrator wahlweise an den Ausgang des Costas-Mischers oder an den Ausgang eines EX-OR-Gliedes schaltbar ist.

Die Umschaltung vor der Integration durch den Integrator (Tiefpaß) ist von Vorteil, weil dadurch kurzzeitige Fehler der VRF-Erkennung keine Rolle spielen. Bei VRF = 1 (57 kHz-Träger vorhanden) wird der Eingang des Integrators auf das EX-OR-Glied (57 kHz-Mischer) geschaltet, und daraus resultiert eine normale PLL-Funktion.

Mit dieser Maßnahme wird der gewünschte Effekt erreicht, daß der 57 kHz-Träger in einer eindeutig definierten Phase einrasten kann, was bei einer Costas-Wirkungsweise nicht der Fall ist.

Weitere zweckmäßige Ausgestaltungen der Erfindung sind in den Unteransprüchen angegeben und der Beschreibung und der Zeichnung zu entnehmen.

Nachfolgend wird die Erfindung zum besseren Verständnis anhand der in der Zeichnung dargestellten Ausführungsbeispiele näher erläutert. Es zeigen:

Fig. 1    ein Prinzipschaltbild einer Phasenregelschleife gemäß einer ersten Ausführungsform eines Demodulators, und

Fig. 2    ein Prinzipschaltbild einer Phasenregelschleife gemäß einer zweiten Ausführungsform eines Demodulators.

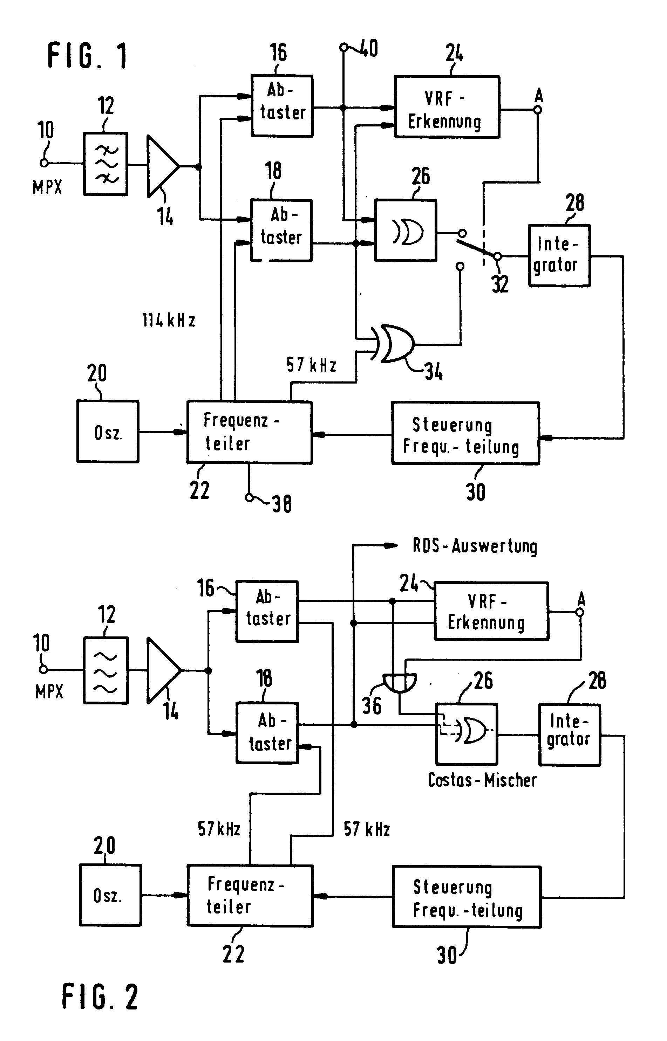

In der Schaltungsanordnung gemäß Fig. 1 liegt an einer Eingangsklemme 10 in üblicher Weise ein an sich bekanntes MPX-Signal an, welches ein aufmoduliertes VRF-Signal und/oder ein aufmoduliertes RDS-Signal enthält. Durch einen Bandpaß 12 (57 kHz-Filter) wird der Frequenzbereich um 57 kHz herausgefiltert. Auf den Bandpaß 12 folgt ein Komparator 14, dessen binäre Signale zu Abtastschaltungen 16 und 18 gelangen.

Ein Festoszillator 20 und ein beeinflußbarer Frequenzteiler 22 bilden einen steuerbaren digitalen Oszillator (DCO), der mit den beiden Abtastschaltungen 16 und 18 verbunden ist. Die Abtastung erfolgt mit zwei um 180° phasenverschobenen 114 kHz-Signalen.

An die beiden Abtastschaltungen 16 und 18 schließen sich eine VRF-Erkennungsschaltung 24 bzw. ein Costas-Mischer 26 an, die wie in der Hauptanmeldung beschrieben aufgebaut sind. Weiterhin umfaßt die Schaltungsanordnung ein EX-OR-Glied 34, dessen einem Eingang von dem Frequenzteiler 22 57-kHz-Signale zugeführt sind, und dessen anderer Eingang sowohl mit der VRF-Erkennungsschaltung 24 als auch mit dem Costas-Mischer 26 verbunden ist.

An den Costas-Mischer 26 schließt sich ein Integrator 28 an, auf den eine Steuerschaltung 30 folgt, welche den Frequenzteiler 22 ansteuert und beeinflußt.

Am Eingang des Integrators 28 befindet sich ein Schalter 32, dessen Schalterstellung vom VRF-Pegel A am Ausgang der VRF-Erkennungsschaltung 24 abhängt. In der einen Schalterstellung ist der Costas-Mischer 26 mit dem Integrator 28 verbunden, und in der anderen Schalterstellung wird eine Verbindung des Ausgangs des EX-OR-Gliedes 34 mit dem Integrator 28 hergestellt.

In der in Fig. 1 gezeigten Stellung des Schalters 32 ist der Integrator 28 mit dem Ausgang des Costas-Mischers 26 verbunden, und die Schaltungsanordnung arbeitet in einer Costas-Wirkungsweise. In diesem Fall ist kein 57 kHz-Träger vorhanden, d.h., VRF = 0.

Wenn dagegen ein 57 kHz-Träger vorliegt (VRF = 1), wird der Schalter 32 in die untere nicht gezeigte Stellung umgeschaltet, und die EX-OR-Verknüpfung durch das EX-OR-Glied 34 wird wirksam von der Referenzfrequenz 57 kHz und einer Eingangssignalfolge angesteuert. Nunmehr arbeitet die Phasenregelschleife in PLL-Wirkungsweise. Der 57 kHz-Träger rastet in einer eindeutig definierten Phase ein, und an der Ausgangsklemme 38 läßt sich ein VRF-Signal abnehmen, welches in an sich bekannter Weise unter Verwendung eines nicht dargestellten Synchrondemodulators demoduliert werden kann. An der in Fig. 1 noch gezeigten Ausgangsklemme 40 steht übrigens ein RDS-Signal für eine anschließende RDS-Auswertung zur Verfügung.

In der anderen Ausführungsform gemäß Fig. 2 sind entsprechende Schaltungsteile aus Fig. 1 mit den gleichen Bezugsziffern versehen. Die Mischung bzw. Abtastung erfolgt hier mit 57 kHz oder mit einer Subharmonischen davon.

Auch hier wird die Regelung in Abhängigkeit des VRF-Pegels A am Ausgang der VRF-Erkennungsschaltung 24 zwischen einer Costas-Wirkungsweise und einer normalen PLL-Wirkungsweise umgeschaltet. Zu diesem Zweck ist in Fig. 2 ein ODER-Glied 36 vorgesehen, wobei der Costas-Mischer 26 - der in üblicher Weise durch eine EX-OR-Verknüpfung gebildet ist - in die Umschaltung mit einbezogen wird.

Wenn für den VRF-Pegel A = 0 gilt, gelangen die Signale der beiden Abtastschaltungen 16 und 18 direkt bzw. über das ODER-Glied 36 in gewünschter Weise zum Costas-Mischer 26, der damit in Betrieb ist, d.h., es liegt die Costas-Wirkungsweise vor.

Demgegenüber ist das ODER-Glied 36 bei A = 1 außer Betrieb, denn der Ausgang des ODER-Gliedes 36 liegt auf "1". In diesem Fall arbeitet die Schaltung 26 (EX-OR-Verknüpfung) nicht mehr als ein Costas-Mischer, sondern als ein Inverter. Damit liegt die normale PLL-Wirkungsweise vor, bei der die stabile Einrastphase eindeutig Modulo 2 $\pi$ ist (bei der Costas-Wirkungsweise ist die stabile Einrastphase lediglich eindeutig Modulo $\pi$ ).

## Patentansprüche

1. Demodulator zur Demodulation eines Eingangssignals, (10) das ein erstes, einen Träger enthaltendes amplitudenmoduliertes Verkehrsrundfunksignal (VRF-Signal) und/oder ein zweites amplitudenmoduliertes Radiodatensystemsignal (RDS-Signal) mit unterdrücktem Träger aufweist, wobei die beiden Träger frequenzgleich und um 90° gegeneinander phasenverschoben sind, mit Mischern (16, 18), denen das Eingangssignal und je ein Hilfssignal aus einem spannungsgesteuerten Oszillator (VCO 20, 22) zugeführt sind, und mit Sinus- und Cosinuskomponenten darstellenden Signalen, die zu einem Steuersignal für die Ansteuerung des spannungsgesteuerten Oszillators (20, 22) herangezogen sind, wobei eine schnelle VRF-Erkennungsschaltung (24) mit einem das Vorhandensein eines VRF-Pegels repräsentierenden VRF-Ausgang (A) vorgesehen ist, und mit einem Costas-Mischer (26), dadurch gekennzeichnet, daß die Phasenregelschleife des Demodulators in Abhängigkeit des VRF-Pegels (A) zwischen einer normalen PLL-Wirkungsweise in der entweder nur die Sinuskomponente oder nur die Cosinuskomponente zur Phasenregelung herangezogen sind und einer Costas-Wirkungsweise in der Mischprodukte aus den Sinus- und Cosinuskomponenten zur Phasenregelung herangezogen werden, umschaltbar ist.

2. Demodulator nach Anspruch 1, dadurch gekennzeichnet, daß die Umschaltung mittels eines am Ausgang des Costas-Mischers (26) angeordneten zweistufigen Schalters (32) erfolgt, durch den ein auf den Costas-Mischer (26) folgender Integrator (28) wahlweise an den Ausgang des Costas-Mischers (26) oder an den Ausgang eines EX-OR-Gliedes (34) schaltbar ist.

3. Demodulator nach Anspruch 2, dadurch gekennzeichnet, daß das EX-OR-Glied (34) von dem gesteuerten Oszillator (22) und einem Abtaster (18) für die Eingangssignale angesteuert ist.

4. Demodulator nach Anspruch 1, dadurch gekennzeichnet, daß die Umschaltung mittels eines ODER-Gliedes (36) erfolgt, dessen einer Eingang von dem VRF-Pegel (A) angesteuert ist, und dessen anderer Eingang mit einem Abtaster (16) für die Eingangssignale verbunden ist.

5. Demodulator nach Anspruch 4, dadurch gekennzeichnet, daß der Ausgang des ODER-Gliedes (36) zum Costas-Mischer (26) führt.

## Claims

1. Demodulator for the demodulation of an input signal (10), which has a first amplitude-modulated traffic programme signal containing a carrier (traffic programme signal) and/or a second amplitude-modulated radio data system signal (RDS signal) with suppressed carrier, the two carriers being of the same frequency and phase-shifted by 90° with respect to each other, with mixers (16, 18), to which the input signal and in each case an auxiliary signal are fed from a voltage-controlled oscillator (VCO 20, 22), and with signals which represent sine and cosine components and are used for a control signal for the actuation of the voltage-controlled oscillator (20, 22), a fast traffic programme detection circuit (24) with a traffic programme output (A) representing the presence of a traffic programme level being provided, and with a Costa's mixer (26), characterised in that the phase-control loop of the demodulator can be switched over in dependence on the traffic programme level (A) between a normal PLL mode, in which either only the sine components or only the cosine components are used for phase control, and a Costa's mode, in which mixture products from the sine and cosine components are used for phase control.

2. Demodulator according to Claim 1, characterised in that the switching-over is performed by means of a two-stage switch (32) which is arranged at the output of the Costa's mixer (26) and by which an integrator (28) following the Costa's mixer (26) can be switched according to choice to the output of the Costa's mixer (26) or to the output of an EX-OR element (34).

3. Demodulator according to Claim 2, characterised in that the EX - OR element (34) is actuated by the controlled oscillator (22) and a sampler (18) for the input signals.

4. Demodulator according to Claim 1, characterised in that the switching-over is performed by means of an OR element (36), the one input of which is actuated by the traffic programme level (A), and the other input of which is connected to a sampler (16) for the input signals.

5. Demodulator according to Claim 4, characterised in that the output of the OR element (36) leads to the Costa's mixer (26).

## Revendications

1. Démodulateur pour la démodulation d'un signal d'entrée (10), qui comporte un premier signal de radio diffusion du trafic routier (signal VRF), à modulation d'amplitude et comprenant une onde porteuse et/ou un deuxième signal du système de données radio (signal RDS) à modulation d'amplitude avec une onde porteuse atténuée, les deux porteurs ayant la même fréquence et étant en décalage de phases l'un par rapport à l'autre de 90°, avec des mélangeurs (16, 18), auxquels le signal d'entrée et un signal secondaire respectif sont amenés à partir d'un oscillateur VCO (20, 22), et avec des signaux représentant des composants sinus et des composants cosinus, qui sont soumis à un signal de commande pour l'excitation de l'oscillateur (20, 22) commandé en tension, un élément d'identification rapide VRF (24) étant prévu avec une sortie VRF (A) représentant l'existence d'un niveau VRF, et avec un mélangeur de Costa (26),

caractérisé en ce que

la boucle de réglage de phases du démodulateur en fonction du niveau VRF (A) peut être inversée entre un mode de fonctionnement normal PLL, dans lequel sont utilisés soit les composants sinus seul soit les composants cosinus seuls pour le réglage de phases et un mode de fonctionnement de Costa, dans lequel sont utilisés des produits mixtes provenant des composants sinus et des composants cosinus pour le réglage de phases.

2. Démodulateur selon la revendication 1, caractérisé en ce que

l'inversion se fait au moyen d'un commutateur (32) à deux étages placé à la sortie du mélangeur de Costa (26), commutateur grâce auquel un intégrateur (28), faisant suite au mélangeur de Costa (26) peut être branché au choix sur la sortie du mélangeur de Costa (26)- ou sur la sortie d'un élément EX-OU (34).

3. Démodulateur selon la revendication 2, caractérisé en ce que
   - l'élément EX-OU (34) est excité par l'oscillateur (22) et un analyseur (18) pour les signaux d'entrée.

4. Démodulateur selon la revendication 1, caractérisé en ce que
   - l'inversion se fait au moyen d'un élément OU (36) dont une entrée est commandée par le niveau VRF(A), et dont l'autre entrée est reliée à un analyseur (16) pour les signaux d'entrée.

5. Démodulateur selon la revendication 4, caractérisé en ce que
   - la sortie de l'élément OU (36) va au mélangeur de Costa (26).

FIG. 1

FIG. 2